Europäisches Patentamt

European Patent Office

Office européen des brevets

(11) Publication number: **0 321 087**
A1

## EUROPEAN PATENT APPLICATION

(21) Application number: 88310495.2

(22) Date of filing: 08.11.88

(51) Int. Cl.⁴: **H01S 3/02** , **G02B 1/10** ,
**H01L 33/00**

(30) Priority: 14.12.87 GB 8729104

(43) Date of publication of application:
21.06.89 Bulletin 89/25

(84) Designated Contracting States:
AT BE CH DE ES FR GB GR IT LI LU NL SE

(71) Applicant: BRITISH TELECOMMUNICATIONS
public limited company
British Telecom Centre, 81 Newgate Street
London EC1A 7AJ(GB)

(72) Inventor: Elton, David John
47 Lupin Road
Ipswich Suffolk IP2 0XF(GB)
Inventor: Devlin, William John
15 Rowanhayes Close
Ipswich Suffolk IP2 9SX(GB)

(74) Representative: Leng, Francis Edward et al
British Telecom Intellectual Property Unit
Room 1304 151 Gower Street
London WC1E 6BA(GB)

(54) Anti-reflection coatings.

(57) Optical devices, e.g. amplifiers, include anti-reflection coatings of hafnium oxide. The coatings are obtained by low temperature deposition in the presence of oxygen. It is important to adjust the degree of oxidation in order to obtain the target refractive index. Slower rates of deposition and oxidation favour stability of performance parameters. The coatings are useful for application to GaInAsP semiconductors.

## Fig.1.

ANTI-REFLECTION COATINGS A23753 SUBS (WP NO: 0692P)

This invention relates to anti-reflection coatings and in particular to anti-reflection coatings for semiconductor laser devices, eg optical amplifiers.

The use of anti-reflection coatings in laser devices is well established. Some devices, eg distributed feedback lasers (usually called DFB lasers) and external cavity lasers, require a single anti-reflection coating. Other devices, eg optical amplifiers, require two anti-reflection coatings. Although these devices, and the use of anti-reflection coatings therein, are well established a brief description will be given.

A DFB laser comprises an active semiconductor region in which an optical signal is generated. The DFB laser also includes a resonance system which has two components, namely a reflective facet, ideally 100% reflective, which is located at one end of the active region and a diffraction grating which provides wavelength selectivity. The active region also has an exit facet through which the radiation generated in the active region passes as output. Reflections from the exit facet are unwanted because the reflected radiation participates in the generation of radiation but the wavelength differs from that of the main signal. Thus it is desirable to apply an anti-reflection coating to the exit facet.

An external cavity laser comprises an active semiconductor region in which the signal is generated and a separate cavity which is part of a resonant system. There is an internal facet between the active region and the cavity and reflections from the internal facet, not being tuned to the same wavelength as the resonance system, degrade performance. Thus it is desirable to apply anti-reflection coatings to the internal facet.

An optical amplifier also has an active region in which the lasing activity occurs but, because oscillation is highly undesirable, there is no resonance system. One form of amplifier, hereinafter called a single pass amplifier, has an input facet for receiving weak optical signals, eg signals attenuated after long distance transmission. The amplifier also has an output facet through which signals, after amplification by passage through the active region, leave, eg for further transmission. Reflections at the input and output facets degrade the performance, eg by causing oscillation or noise. It is, therefore, conventional to apply anti-reflection coatings to both the input and output facets.

In an alternative form of amplifier, hereinafter called a double pass amplifier, one facet serves for both input and output. In use such amplifiers are associated with directional couplers to separate input and output signals. In these amplifiers the signal passes twice through the active region and the decibel gain is doubled. The input/output facet is provided with an anti-reflection coating but the other facet needs a mirror coating with a high, ideally 100%, reflectivity.

In many devices the active region is formed of a semiconductor which contains at least one of Ga and In and at least one of P and As, eg mixed compounds of the formula $Ga_xIn_{(1-x)}As_yP_{(1-y)}$ where x is in the range 0.2 to 0.4 and y is in the range 0.5 to 0.9. There is therefore substantial interest in selecting an anti-reflection coating which is suitable for use on these semiconductor materials.

Many oxides have been proposed for this purpose, eg oxides of Y, Gd, Nd and Si. Indeed very low reflectivities have been achieved, eg of the order $10^{-4}$, but other factors have also to be taken into account, eg the stability of the coating. The ease and reproducability with which the coating may be deposited is also important. It is an object of this invention to provide coatings which have acceptably low levels of reflectivity, adequate stability and which can be deposited reproducably.

European patent specification 259919 (which designates DE, FR, GB, NL and SE) was published on 16 March 1988 (priority date 1 January 1986 in Netherlands) which is three months after the priority date of this application. It describes the use of $HfO_2$ as an antireflection coating containing forms of distributed feedback lasers. InP and $Ga_{(1-x)}As_yP_{(1-y)}$ are named as substrates.

We have found that the use of hafnium oxide as the coating material meets these requirements. The coatings are preferably 180 to 220nm thick.

It is known that hafnium oxide exists in non-stoichiometric forms. Thus it can be represented by the formula $HfO_n$ where n is slightly less than 2. It is not possible to ascertain the value of n in a coating layer but the refractive index of the coating is related to its degree of oxidation. The refractive index is also related to the occurrence of voids within the coating. Thus it is desirable that the coating should have a refractive index, measured at 632.8nm, in the range 1.87 to 2.00 and a packing density in the range 0.86 to 0.96. The method of determining the packing density will be given below.

The coatings according to the invention are conveniently produced by deposition from the vapour phase in the presence of oxygen at low pressure, eg below $10^{-3}$mbar. It is preferred to deposit the coating at a rate of 0.1 to 1nm/s preferably 0.2nm/s, under an oxygen pressure of between 1 and $5 \times 10^{-4}$mbar.

It is usually convenient to coat a target comprising 20 to 50 devices. After coating the target is cut into separate devices and electrical connectors are attached. Optical fibre may also be attached.

The invention will now be described by way of example with reference to the accompanying drawings in which:

Figure 1 shows an amplifier according to the invention; and

Figure 2 shows a conventional coating apparatus suitable for depositing coatings according to the invention.

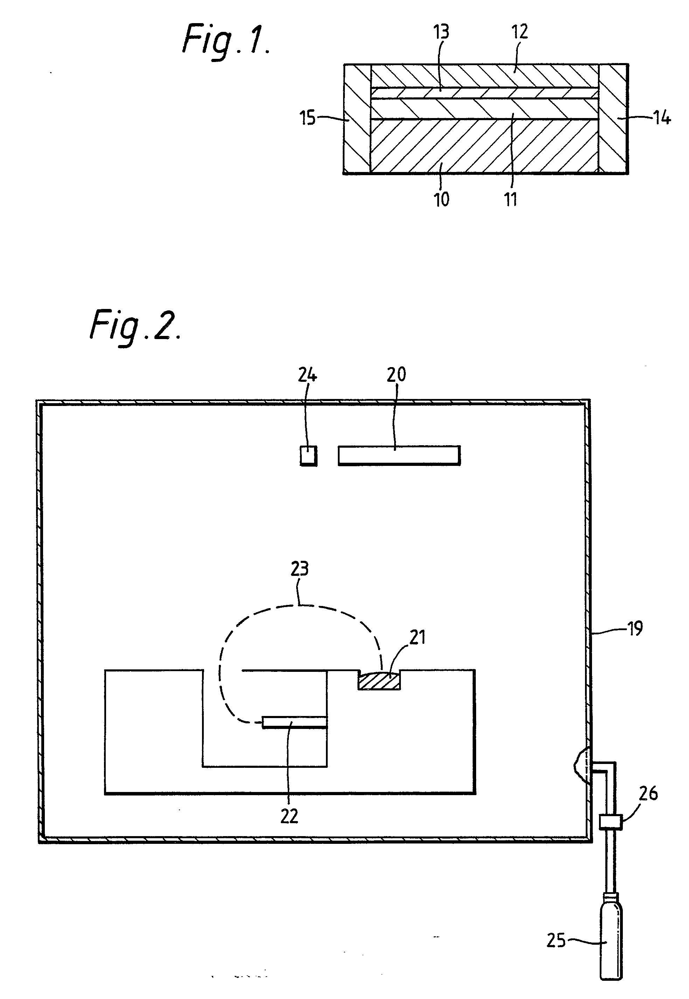

As shown in Figure 1, the amplifier comprises a substrate 10 of InP. The substrate performs no function in the finished device. It provides support for the other layers which were grown onto the substrate.

The operative layers are confining layers 11 and 12 which are formed of p and n type InP respectively. The active layer 13, an indium gallium arsenide phosphide semiconductor, is located between the confining layers 11 and 12. The active layer 13 has a higher refractive index than the two confining layers. The two end facets of the amplifier are coated with anti-reflection coatings 14 and 15 formed of hafnium oxide having a refractive index of 1.87 to 2.00 and a packing density of 0.91. (Note the refractive index range 1.87 to 2.00 applies when the index is measured with radiation of wavelength 632.8nm. If measured at the wavelength of use, eg 1.55$\mu$m, the preferred refractive index is 1.84). The performance of these anti-reflection coatings is matched to the properties of the active layer 13.

During the use of the device electrons change energy levels and thereby generate signal quanta within the active layer 13. This change of energy level is stimulated by the presence of signal quanta which are received via coating 15. These quanta and those generated during this passage leave the device via coating 14. Ideally all of the quanta would leave the device but, because an ideal can never be fully achieved, some quanta will be reflected back into the device. The reflected quanta will be amplified and an equivalent reflection will occur at coating 15. Thus there is a possibility of reflections and the first requirement of the anti-reflection coatings is to reduce the level of these reflections to such an extent that lasing (ie oscillation) will not occur under the amplifier's conditions of use. Even if self-sustaining oscillations do not occur there may be some noise due to the amplification of unwanted reflections. If the level of oxidation can be optimised, the hafnium oxide can not only suppress the lasing but substantially reduce this noise. For gains of over 20dB reflectivities below 0.5%, preferably below 0.2%, are appropriate. For gains of 30dB even lower reflectivities, eg below 0.05%, would be needed.

The anti-reflection coatings according to the invention are applied using a conventional vapour deposition apparatus.

The apparatus shown in Figure 2 comprises a vacuum chamber 19 which is connected to evacuation pumps (not shown). The chamber 19 contains the target 20 and a source 21 which is a hafnium oxide contained in a suitable crucible. During deposition the target 20 is heated to 300° C. The source is heated and thereby caused to evaporate by an electron beam 23 which is generated by an electron gun 22. A magnetic field (the mode of generation is not shown) is applied to cause the electrons to follow a curved path to impinge on the source 21. Varying the field causes the point of impact to wander so that hafnium oxide is evaporated from different parts of the source. Thus source material is evaporated so that it rises to deposit on target 20.

During deposition the vacuum chamber 19 contains an atmosphere of oxgyen at a pressure between $1 \times 10^{-4}$ and $5 \times 10^{-4}$ mbar. In order to provide this pressure, oxygen is continuously leaked into the chamber 19 from a cylinder 25 via a leak valve 26. The evacuation pumps run continuously and the rate of supply of oxygen is adjusted so that the pressure is steady at the selected value. (Before adding any oxygen, the chamber 19 is evacuated to about $5 \times 10^{-9}$ mbar. Thus the oxygen atmosphere is substantially pure).

The chamber 19 also contains a piezo-electric crystal 24 which is adjacent to the target 20 so that hafnium oxide deposits on both simultaneously. The frequency of oscillation of the crystal 24 is affected by the deposit. The crystal is calibrated in known manner and its frequency of oscillation is continuously monitored during deposition whereby the thickness and rate of growth are continuously available.

The final thickness of the coating should be about 0.25 to 0.27, preferably 0.26, of a wavelength (as measured inside the coating) of the intended signals. (Note. If the wavelength of the intended signals is measured in vacuo the thickness is 0.12 to 0.14 of the wavelength). Thus for signals with wavelengths of 1.3$\mu$m to 1.5$\mu$m in vacuo, coating thicknesses of about 186nm to 220nm are suitable. We recommend about 186nm for 1.3$\mu$m and 215 for 1.5$\mu$m. The quartz crystal 24 detects the end point when the coating on the target has achieved the appropriate thickness.

It is convenient to use targets which contain several devices, eg about 30 devices, at one time. After coating (both facets) the target is cut into individual devices which are mounted for use. During coating the target is held in a conventional holder.

Using the apparatus described above oxygenated coatings of hafnium oxide were applied to semiconductor devices.

We have found that the performance of hafnium oxide is substantially affected by the conditions under which it was deposited and conditions which favour substantially complete oxygenation appear to favour the lowest (most desirable) reflectivities. Unfortunately the oxygen in the vacuum chamber 19 appears to exert a disadvantageous effect on the other properties of the coating, eg the coating may be slightly porous and hence its refractive index may change after deposition.

In order to take account of both effects we prefer to deposit the coating slowly, eg at a rate of less than 2nm/s, eg 0.1 to 1 nm/s, under a low oxygen pressure, eg 2 to $5 \times 10^{-4}$ mbar.

The degree of oxidation can be measured by the refractive index of the coating and the target values are 1.87 to 2.00 measured at 632.8nm. The degree of porosity can be measured by the change of refractive index after very prolonged storage in air saturated with water vapour at 25°C.

The refractive index rises on exposure to moist air and the change in question is between the initial value, $N_o$, and the highest attainable value, $N_H$, (which is usually attained after several months' exposure).

[If the sample is saturated then $N_H$ is measured first and the sample is dried, eg by heating at 300°C for 30 minutes in vacuo, and $N_o$ is measured second.]

The packing density, q, is given by
$$q = (0.33 + N_o - N_H)/0.33$$
The refractive index, N, of the hafnium oxide per se is given by
$$N = (1.33 N_o - N_H)/(0.33 + N_o - N_H)$$

EXAMPLE 1

Using the technique described above a target in the form of a strip of 30 devices designed for operation at 1.5$\mu$m was heated to 300°C and exposed to hafnium oxide vapour in the presence of oxygen at $3.4 \times 10^{-4}$ mbar. A coating 218nm thick was grown at 1.0nm/s. The target was treated twice so that two facets were coated.

Immediately after coating the refractive index was 1.941 and after saturation with water vapour (by exposure to saturated air for 3000 hrs at 30°C) the index rose to 1.971. This implies a packing density of 0.91 and that the refractive index of the hafnium oxide itself was 2.035. (All the refractive indices were measured at wavelength 632.8nm).

The strip of 30 devices was cut into individual amplifiers and a gain of 28dB was achieved without oscillation. This implies a reflectivity below 0.2% for the coatings.

EXAMPLE 2

In further experiments, a target in the form of a strip of 30 devices designed for operation at 1.5$\mu$m was heated to 300°C and exposed to hafnium oxide vapour in the presence of oxygen at $3.1 \times 10^{-4}$ mbar. A coating 182nm thick was grown at 0.2nm/s. The target was treated twice so that two facets were coated.

Immediately after coating the refractive index was 1.916 and after saturation with water vapour (by exposure to saturated air at 30°C) the index rose to 1.943. This implies a packing density of 0.915 and that the refractive index of the hafnium oxide itself was 2.000.

The strip of 30 devices was cut into individual amplifiers and a gain of 28dB was achieved without oscillation. This implies a reflectivity below 0.2% for the coatings.

Examples 1 and 2 describe coatings wherein the hafnium oxide itself has a refractive index of 2.034 and 2.000 respectively. The value 2.034 is above the target range of 2.00 to 1.87 whereas the value 2.000 is at the top end of the range. Since the refractive index tends to decrease as the degree of oxidation increases, it appears that the oxidation conditions employed in Example 2 are more efficatious.

The deposition methods also produce pores in the coatings and the presence of the pores reduces the refractive index. Thus the pores provide a valuable control in reducing the refractive index to values which would be difficult to achieve by oxidation. Thus, in Example 2, the coating as a whole has a refractive index of 1.916 (because the packing density is 0.915) and this lower value is better than the "oxide" value of 2.000.

The pores also represent a source of instability because impurities, eg water vapour, can diffuse into them. However, this is not a serious disadvantage because the amplifier is encapsulated during use and in any case the total volume of the pores is small when the packing density is greater than 0.9.

It is conventional to encapsulate an amplifier during use. The fibres are placed close to the coatings so that the actual interface is air/hafnium oxide. The encapsulating material surrounds the ends of the fibre and the amplifier and it does not intrude into the path of the radiation.

## Claims

1. An opto-electronic or electro-optic device having an anti-reflection coated facet for the transmission of optical radiation, wherein said coating is hafnium oxide.

2. A device according to claim 1, wherein said coating is applied to a semiconductor material formed of at least one of Ga and In and at least one of As and P.

3. A device according to claim 2, wherein said coating is applied to a semiconductor material formed of all of Ga, In, As and P.

4. A device according to claim 3, wherein the device has an active layer of indium gallium phosphide arsenide located between confining layers of indium phosphide.

5. A device according to any one of the preceding claims, wherein the coating has a refractive index, measured at wavelength 632.8nm, in the range 1.87 to 2.00.

6. A device according to any one of the preceding claims in which the coating has a packing density in the range 0.86 to 0.96.

7. A device according to any one of the preceding claims, wherein the coating has a reflectance of less than 0.5%.

8. A single pass optical amplifier according to any one of the preceding claims, which includes two coatings as specified, i.e. one coating on the input facet and one on the output facet.

9. A double pass optical amplifier which has an anti-reflection coating according to any one of claims 1 to 6, on the input/output facet and a mirror coating on the other facet.

10. A method of depositing a coating as specified in claim 1, which method comprises exposing the facet to be coated to hafnium oxide in the vapour phase and in the presence of an atmosphere of oxygen at a pressure of $10^{-4}$ to $10^{-3}$mbar and depositing the coating at a rate of less than 2nm/s.

Fig.1.

Fig.2.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,P X | EP-A-0 259 919 (PHILIPS' GLOEILAMPENFABRIEKEN) <br> * Claim 1 * <br> --- | 1 | H 01 S 3/02 <br> G 02 B 1/10 <br> H 01 L 33/00 |
| A | PATENT ABSTRACTS OF JAPAN, vol. 10, no. 364 (P-524)[2421], 5th December 1986; & JP-A-61 159 602 (OLYMPUS OPTICAL CO. LTD) 19-07-1986 <br> * Whole abstract * <br> --- | 1 | |
| A | EP-A-0 204 540 (BRITISH TELECOMMUNICATIONS) <br> * Claims 1,11,12; page 2, lines 15-18; page 3, lines 7-23; figure 1 * <br> --- | 1,2,4,9 ,10 | |
| A | EP-A-0 168 165 (BRITISH TELECOMMUNICATIONS) <br> * Claims 1,8 * <br> ----- | 1,8 | |
| | | | TECHNICAL FIELDS SEARCHED (Int. Cl.4) <br><br> H 01 S <br> H 01 L <br> G 02 B |

The present search report has been drawn up for all claims

| Place of search | Date of completion of the search | Examiner |
|---|---|---|
| THE HAGUE | 24-02-1989 | FARNESE G.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................

& : member of the same patent family, corresponding document

EPO FORM 1503 03.82 (P0401)